# EUROPÄISCHE PATENTSCHRIFT

(11) **EP 1 766 702 B1**
(45) Veröffentlichungstag und Bekanntmachung des Hinweises auf die Patenterteilung: **15.10.2008**
(21) Anmeldenummer: 05772623.4
(22) Anmeldetag: 14.07.2005
(51) Int. Cl.: H01L 51/00

(54) **VERWENDUNG VON POLYMEREN FÜR UP-CONVERSION UND VORRICHTUNGEN ZUR UP-CONVERSION**
USE OF POLYMERS FOR UP-CONVERSION AND DEVICES FOR UP-CONVERSION
UTILISATION DE POLYMERES ET DISPOSITIFS POUR LA CONVERSION-ELEVATION (UP-CONVERSION)

(30) Priorität: 15.07.2004 DE 102004034140
(43) Veröffentlichungstag der Anmeldung: 28.03.2007
(73) Patentinhaber: Merck Patent GmbH, 64293 Darmstadt (DE)
(72) Erfinder: HEUN, Susanne, 65812 Bad Soden (DE); BÜSING, Arne, 65929 Frankfurt (DE); BREUNING, Esther, 65527 Niedernhausen (DE); LUDEMANN, Aurélie, 60322 Frankfurt (DE); LAQUAI, Frédéric, Cambridge CB4 3SA (GB); IM , Chan, Seoul 132-863 (KR)
(86) Internationale Anmeldenummer: PCT/EP2005/007671
(87) Internationale Veröffentlichungsnummer: WO 2006/008068

(56) Entgegenhaltungen:
- WO-A-98/43072
- WO-A-02/077060
- US-A1- 2003 030 067
- US-A1- 2003 094 626
- KEIVANIDIS PANAGIOTIS E ET AL: "Up-Conversion Photoluminescence in Polyfluorene Doped with Metal(II)-Octaethyl Porphyrins" ADVANCED MATERIALS, Bd. 15, Nr. 24, 17. Dezember 2003 (2003-12-17), Seiten 2095-2098, XP002352203 in der Anmeldung erwähnt
- S.A. BAGNICH UND H. BÄSSLER: "Origin of delayed fluorescence of a ladder-type methyl-poly(para-phenylene) doped with Pt(II)octaethylporphyrin" CHEMICAL PHYSICS LETTERS, Bd. 381, 24. Oktober 2003 (2003-10-24), Seiten 464-470, XP002352204 in der Anmeldung erwähnt
- "Upconversion dye-doped polymer fiber laser" APPLIED PHYSICS LETTERS, Bd. 68, Nr. 25, 17. Juni 1996 (1996-06-17), Seiten 3549-3551, XP012015513 ISSN: 0003-6951 in der Anmeldung erwähnt

## Beschreibung

Das Phänomen "Up-conversion", also der Erzeugung von Photonen höherer Energie durch gleichzeitige oder sequenzielle Absorption von zwei oder mehr Photonen geringerer Energie, wurde an einer Reihe organischer Materialien bereits beobachtet (T. Kojei et al., Chem. Phys. Lett. 1998, 298, 1; G. S. He et al., Appl. Phys. Lett. 1996, 68, 3549; R. Schroeder et al., J. Chem. Phys. 2002, 116, 3449; J. M. Lupton, Appl. Phys. Lett. 2002, 80, 186; C. Bauer et al., Adv. Mater. 2002, 14, 673). Dieses Phänomen ist häufig mit der Anwendung relativ hoher Lichtintensitäten von gepulsten Lasern verbunden. Beschriebene Mechanismen hierfür sind Zwei-Photonen-Absorption von Molekülen mit hohem Zwei-Photonen-Absorptionsquerschnitt (ein nicht-linear-optischer Effekt), Anregung in höher angeregte Zustände durch hohe Pumpintensitäten oder mehrstufige Anregungsprozesse. Da die Nutzung dieser Mechanismen mit einem relativ großen Aufwand verbunden ist, stellen sie ein Hindernis für die praktische Anwendung dar. Diese wäre aber sehr wünschenswert, da oft nur der energiereichere Teil des Spektrums (blau) für Anwendungen wirksam ist. Up-conversion ermöglicht es, auch den energieärmeren röteren Anteil des Spektrums zu nutzen. So liegt eine mögliche Anwendung für Up-conversion im Bereich organischer Solarzellen (O-SC). Dadurch kann nicht nur blaues und UV-Licht genutzt werden, um aus Licht freie Ladungsträger zu erzeugen, sondern auch grünes oder sogar rotes Licht, wenn daraus energiereicheres blaues Licht oder gegebenenfalls direkt die freien Ladungsträger erzeugt werden können. Eine weitere Anwendung liegt im Bereich organischer Leuchtdioden, beispielsweise zur Erzeugung blauen Lichts oder zur Erzeugung weißen Lichts durch gleichzeitige Emission von blau und rot/gelb. Es sind jedoch auch weitere Anwendungen möglich, z. B. im Bereich organischer blauer Laser, die mit kommerziell erhältlichen grünen Lasern gepumpt werden können. So können die Streuung und die lineare Absorption reduziert und die Photostabilität des Materials erhöht werden. Eine weitere Anwendungsmöglichkeit ist beispielsweise bei Vernetzungsreaktionen, wobei durch Verwendung von grünem Licht UV-Licht erzeugt werden kann, dessen Einwirkung auf einen Sensibilisator die Vernetzungsreaktion initiieren kann. Nochmals eine weitere Anwendungsmöglichkeit sind Schalter, bei denen nur eine bestimmte Wellenlänge, bei der ein relativ schmalbandiger Sensibilisator absorbiert, die Emission von blauem Licht triggert. Weiterhin möglich sind Systeme zur optischen Datenspeicherung, chemische Sensoren, Temperatursensoren, biologische bzw. medizinische Anwendungen, etc.

Vor kurzem wurde Up-conversion in einem System aus einem methylsubstituierten Leiterpolymer (MeLPPP), dotiert mit Platin-octaethylporphyrin (PtOEP) als Sensibilisator, (S. A. Bagnich, H. Bässler, Chem. Phys. Lett. 2003, 381, 464), an Polyfluoren, dotiert mit Palladium-octaethylporphyrin (PdOEP) als Sensibilisator (EP 1484379) und an Polyfluoren, dotiert mit Metall(II)-octaethylporphyrin, (P.E. Keivanidis et al., Adv. Mater. 2003, 15, 2095) beschrieben. Durch die Anwesenheit des Metallkomplexe konnten die Pumpintensitäten des Lasers um fünf Größenordnungen reduziert werden im Vergleich zur Up-conversion an einfachen Polyfluoren-Systemen, die keine Metallkomplexe enthielten. Jedoch ist die Effizienz der Up-conversion weiterhin gering, das Verhältnis der integrierten Photolumineszenz des Polyfluorens bei Anregung des Metallkomplexes im Vergleich zur direkten Anregung des Polyfluorens wurde für Palladium-porphyrin zu 1 : 5000 ermittelt. Durch die Verwendung von Platin-porphyrin konnte die Effizienz um den Faktor 18 verbessert werden, so dass sich ungefähr ein Verhältnis von 1 : 300 ergibt. Man erhält jedoch in diesen Systemen überwiegend die Emission des Metallkomplexes, wie von einem klassischen Matrix-Gast-System zu erwarten ist.

Durch das System aus Polyfluoren und Metallporphyrin-Komplex als Sensibilisator konnte die Effizienz der Up-conversion also bereits deutlich gesteigert werden. Jedoch wäre es für die Anwendung wünschenswert, eine weitere deutliche Steigerung der Up-conversion zu erreichen und die Emission der schwermetallhaltigen Verbindung weiter zu reduzieren. So war es Aufgabe dieser Arbeiten, die Effizienz der Up-conversion von 1 : 5000 bzw. 1 : 300 um mindestens eine Größenordnung auf über 1 : 30 zu steigern.

Es wurde überraschend gefunden, dass Polymere zusammen mit Verbindungen, die Schweratome mit der Ordnungszahl größer 38 enthalten (Sensibilisator), insbesondere dann sehr gute und den Stand der Technik übertreffende Eigenschaften in Bezug auf die Effizienz der Up-conversion aufweisen, wenn das niedrigste Triplett-Niveau des Sensibilisators höher liegt als das niedrigste Triplett-Niveau des Polymers. Dadurch konnte die Effizienz der Up-conversion um mehr als eine Größenordnung gesteigert werden (von 1 : 300 auf mehr als 1 : 30).

Weiterhin wurde überraschend gefunden, dass Polymere, die kondensierte aromatische Ringsysteme enthalten, zusammen mit Verbindungen, die Schweratome enthalten (Sensibilisator) ebenfalls sehr gute und den Stand der Technik übertreffende Eigenschaften in Bezug auf die Effizienz der Up-conversion aufweisen.

Die Verwendung derartiger Systeme zur Up-conversion, ebenso wie optische und elektronische Vorrichtungen zur Up-conversion, die diese Systeme enthalten, sind daher Gegenstand der vorliegenden Erfindung.

Gegenstand der Erfindung ist daher die Verwendung von Systemen, enthaltend mindestens ein Polymer und mindestens einen Sensibilisator, der mindestens ein Schweratom mit der Ordnungzahl größer 38 enthält, dadurch gekennzeichnet, dass das Triplett-Niveau des Sensibilisators höher liegt als das Triplett-Niveau des Polymers, bevorzugt mindestens 0.05 eV höher, besonders bevorzugt mindestens 0.1 eV höher, für Up-conversion.

Unter dem Begriff "Up-conversion" im Sinne dieser Erfindung wird die Erzeugung von Photonen höherer Energie bzw. elektronischen Zuständen höherer Energie nach Absorption von Photonen geringerer Energie verstanden. Sie kann in den erfindungsgemäßen Systemen nach den bekannten und beschriebenen Mechanismen oder wie bei P. E. Keivanidis (Adv. Mater. 2003,15,2095) beschrieben ablaufen. Ebenso wird unter diesem Begriff die Erzeugung höherenergetischer Photonen aus elektrisch erzeugten angeregten Zuständen niedrigerer Energie verstanden.

Gegenstand der Erfindung ist weiterhin die Verwendung von Systemen, enthaltend mindestens ein Polymer und mindestens einen Sensibilisator, der mindestens ein Schweratom mit der Ordnungzahl größer 38 enthält, dadurch gekennzeichnet, dass das Polymer mindestens 1 mol%, bevorzugt mindestens 5 mol%, besonders bevorzugt mindestens 10 mol% eines kondensierten aromatischen Ringsystems enthält, für Up-conversion, insbesondere in elektronischen und/oder optischen Vorrichtungen.

In einer bevorzugten Ausführungsform der Erfindung liegt das Triplett-Niveau des Sensibilisators höher als das Triplett-Niveau des Polymers und gleichzeitig enthält das Polymer mindestens 1 mol%, bevorzugt mindestens 5 mol%, besonders bevorzugt mindestens 10 mol% eines kondensierten aromatischen Ringsystems.

Unter der Triplett-Energie einer Verbindung wird die Energiedifferenz zwischen dem niedrigsten Triplettzustand T1 und dem Singulett-Grundzustand S0 verstanden. Die Lage des Singulett-Grundzustands S0 wird bevorzugt mittels Cyclovoltammetrie durch Bestimmung des Oxidationspotenzials (Energielevel des HOMO) relativ zu einem bekannten Standard ermittelt. Die Energiedifferenz zwischen T1 und S0 wird bevorzugt spektroskopisch bestimmt, wie z. B. von D. Hertel et al. (J. Chem. Phys. 2001, 115, 10007) beschrieben. Die absolute Lage des Triplett-Niveaus bezüglich des Vakuumpotenzials E = 0 ergibt sich aus der Summe der Energie des Grundzustandes S0 (Energielevel des HOMO) und der spektroskopisch bestimmten Energiedifferenz zwischen T1 und S0.

Unter einem Sensibilisator im Sinne dieser Erfindung wird eine Verbindung verstanden, die Licht im Bereich der eingestrahlten Wellenlänge absorbiert, dadurch in einen Triplett-Zustand übergeht und diesen gegebenenfalls nachfolgend auf das Polymer übertragen kann. Bevorzugt liegt dabei das Triplett-Niveau des Sensibilisators oberhalb des Triplett-Niveaus des Polymers.

Der Sensibilisator enthält mindestens ein Schweratom mit der Ordnungszahl größer 38, bevorzugt ein Übergangsmetall mit der Ordnungszahl größer 38, besonders bevorzugt Wolfram, Ruthenium, Osmium, Rhodium, Iridium, Palladium, Platin oder Gold. Alternativ kann der Sensibilisator auch kovalent mit dem Polymer verknüpft sein, so dass dann ein einziges Copolymer als Up-conversion-System verwendet werden kann.

Unter einem kondensierten aromatischen Ringsystem im Sinne dieser Erfindung werden Ringsysteme verstanden, in denen mindestens zwei aromatische oder heteroaromatische Ringe, beispielsweise Benzolringe, miteinander "verschmolzen", d. h. durch Anellierung einander ankondensiert sind, also mindestens eine gemeinsame Kante und dadurch auch ein gemeinsames aromatisches System aufweisen. Diese Ringsysteme können substituiert oder unsubstituiert sein; ebenso können gegebenenfalls vorhandene Substituenten weitere Ringsysteme bilden. So sind beispielsweise Systeme wie Naphthalin, Anthracen, Phenanthren, Pyren, etc. als kondensierte aromatische Ringsysteme zu sehen, während beispielsweise Biphenyl, Fluoren, Spirobifluoren, etc. keine kondensierten aromatischen Ringsysteme darstellen.

Das Polymer kann konjugiert, teilkonjugiert oder nicht-konjugiert sein. In einer bevorzugten Ausführungsform ist das Polymer konjugiert oder teilkonjugiert, in einer besonders bevorzugten Ausführungsform ist das Polymer konjugiert.

Konjugierte Polymere im Sinne dieser Erfindung sind Polymere, die in der Hauptkette hauptsächlich sp²-hybridisierte (bzw. auch sp-hybridisierte) Kohlenstoffatome enthalten, die auch durch entsprechende Heteroatome ersetzt sein können. Dies bedeutet im einfachsten Fall abwechselndes Vorliegen von Doppel- und Einfachbindungen in der Hauptkette. Hauptsächlich meint, dass natürlich (ohne weiteres Zutun) auftretende Defekte, die zu Konjugationsunterbrechungen führen, den Begriff "konjugiertes Polymer" nicht entwerten. Des Weiteren wird in diesem Anmeldetext ebenfalls als konjugiert bezeichnet, wenn sich in der Hauptkette Arylamineinheiten, Arylphosphineinheiten und/oder bestimmte Heterocyclen (d. h. Konjugation über N-, O-, S- oder P-Atome) und/oder metallorganische Komplexe, wie beispielsweise Iridium- oder Platin-Komplexe (Konjugation über das Metallatom), befinden. Teilkonjugierte Polymere im Sinne dieser Erfindung sind Polymere, die entweder in der Hauptkette längere konjugierte Abschnitte enthalten, die durch nicht-konjugierte Abschnitte unterbrochen sind, oder die in den Seitenketten eines in der Hauptkette nicht-konjugierten Polymers längere konjugierte Abschnitte enthalten. Hingegen würden Einheiten, wie beispielsweise einfache Alkylenketten, (Thio)Etherbrücken, Ester-, Amid- oder Imidverknüpfungen eindeutig als nicht-konjugierte Segmente definiert.

Die kondensierten aromatischen Ringsysteme können erfindungsgemäß in die Haupt- und/oder in die Seitenkette des Polymers eingebaut werden. Bei Einbau in die Seitenkette besteht die Möglichkeit, dass die Ringsysteme in Konjugation mit der Polymerhauptkette stehen oder dass sie nicht-konjugiert zur Polymerhauptkette sind. In einer bevorzugten Ausführungsform der Erfindung stehen die kondensierten aromatischen Ringsysteme in Konjugation mit der Polymerhauptkette. In einer besonders bevorzugten Ausführungsform der Erfindung sind die kondensierten aromatischen Ringsysteme Teil der Polymerhauptkette.

Bevorzugt enthalten die kondensierten aromatischen Ringsysteme zwischen zwei und acht aromatische Einheiten, die jeweils über eine oder mehrere gemeinsame Kanten einander ankondensiert sind und dadurch ein gemeinsames aromatisches System ausbilden und die substituiert oder unsubstituiert sein können, wobei die Substituenten noch weitere Ringsysteme bilden können.
Besonders bevorzugt enthalten die kondensierten aromatischen Ringsysteme zwischen zwei und sechs aromatische Einheiten, insbesondere zwischen drei und fünf aromatische Einheiten, die jeweils über eine oder mehrere gemeinsame Kanten einander ankondensiert sind und dadurch ein gemeinsames aromatisches System ausbilden und die substituiert oder unsubstituiert sein können, wobei die Substituenten auch weitere Ringsysteme bilden können.
Ganz besonders bevorzugt sind die einander-ankondensierten aromatischen Einheiten ausgewählt aus Benzol, Pyridin, Pyrimidin, Pyrazin, Pyridazin und Thiophen, die substituiert oder unsubstituiert sein können, besonders bevorzugt Benzol und Pyridin, die substituiert oder unsubstituiert sein können. Dabei sind mögliche Substituenten ausgewählt aus C₁ bis C₄₀ kohlenstoffhaltigen Gruppen.
Im Rahmen der vorliegenden Erfindung werden unter einer C₁-C₄₀-kohlenstoffhaltigen Gruppe bevorzugt die Reste C₁-C₄₀-Alkyl, besonders bevorzugt Methyl, Ethyl, n-Propyl, i-Propyl, n-Butyl, i-Butyl, s-Butyl, t-Butyl, n-Pentyl, s-Pentyl, Cyclopentyl, n-Hexyl, Cyclohexyl, n-Octyl oder Cyclooctyl, C₁-C₄₀-Alkenyl, besonders bevorzugt Ethenyl, Propenyl, Butenyl, Pentenyl, Cyclopentenyl, Hexenyl, Cyclohexenyl, Octenyl oder Cyclooctenyl, C₁-C₄₀-Alkinyl, besonders bevorzugt Ethinyl, Propinyl, Butinyl, Pentinyl, Hexinyl oder Octinyl, C₁-C₄₀-Fluoralkyl, besonders bevorzugt Trifluormethyl, Pentafluorethyl oder 2,2,2-Trifluorethyl, C₆-C₄₀-Aryl, besonders bevorzugt Phenyl, Biphenyl, Naphthyl, Anthracenyl, Triphenylenyl, [1,1';3',1"]Terphenyl-2'-yl, Binaphthyl oder Phenanthrenyl, C₆-C₄₀-Fluoraryl, besonders bevorzugt Pentafluorophenyl, 3,5-Bistrifluoromethylphenyl, Pentafluorobenzyliden, 3,5-Bistrifluoromethylbenzyliden, Tetrafluorophenyl oder Heptafluoronaphthyl, C₁-C₄₀-Alkoxy, besonders bevorzugt Methoxy, Ethoxy, n-Propoxy, i-Propoxy, n-Butoxy, i-Butoxy, s-Butoxy oder t-Butoxy, C₆-C₄₀-Aryloxy, besonders bevorzugt Phenoxy, Naphthoxy, Biphenyloxy, Anthracenyloxy, Phenanthrenyloxy, C₇-C₄₀-Arylalkyl, besonders bevorzugt o-Tolyl, m-Tolyl, p-Tolyl, 2,6-Dimethylphenyl, 2,6-Diethylphenyl, 2,6-Di-i-propylphenyl, 2,6-Di-t-butylphenyl, o-t-Butylphenyl, m-t-Butylphenyl, p-t-Butylphenyl, C₇-C₄₀-Alkylaryl, besonders bevorzugt Benzyl, Ethylphenyl, Propylphenyl, Diphenylmethyl, Triphenylmethyl oder Naphthalinylmethyl, C₇-C₂₀-Aryloxyalkyl, besonders bevorzugt o-Methoxyphenyl, m-Phenoxymethyl, p-Phenoxymethyl, C₁₂-C₄₀-Aryloxyaryl, besonders bevorzugt p-Phenoxyphenyl, C₂-C₄₀-Heteroaryl, besonders bevorzugt 2-Pyridyl, 3-Pyridyl, 4-Pyridyl, Chinolinyl, Isochinolinyl, Acridinyl, Benzochinolinyl oder Benzoisochinolinyl, C₄-C₄₀-Heterocycloalkyl, besonders bevorzugt Furyl, Benzofuryl, 2-Pyrolidinyl, 2-Indolyl, 3-Indolyl, 2,3-Dihydroindolyl, C₈-C₄₀-Arylalkenyl, besonders bevorzugt o-Vinylphenyl, m-Vinylphenyl, p-Vinylphenyl, C₈-C₄₀-Arylalkinyl, besonders bevorzugt o-Ethinylphenyl, m-Ethinylphenyl oder p-Ethinylphenyl, C₂-C₄₀-heteroatomhaltige Gruppe, besonders bevorzugt Carbonyl, Benzoyl, Oxybenzoyl, Benzoyloxy, Acetyl, Acetoxy oder Nitril verstanden, wobei eine oder mehrere C₁-C₄₀-kohlenstoffhaltige Gruppen ein cyclisches System bilden können.

Beispiele für besonders bevorzugte kondensierte aromatische Ringsysteme sind Strukturen gemäß den Formeln (1) bis (24), die jeweils an beliebigen Positionen eine, zwei oder mehr Verknüpfungen zum Polymer aufweisen, bevorzugt zwei Verknüpfungen zum Polymer, und die jeweils mit einem oder mehreren Substituenten R substituiert sein können, wobei die Anzahl der Substituenten R maximal der Zahl substituierbarer H-Atome entspricht:

| | | |
|---|---|---|
| 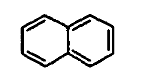 | 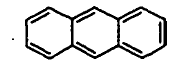 | 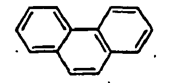 |
| Formel (1) | Formel (2) | Formel. (3) |
| 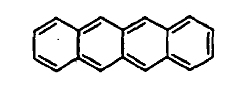 | 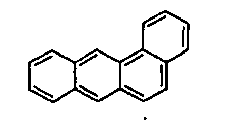 | 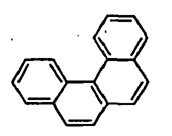 |
| Formel (4) | Formel (5) | Formel (6) |
| 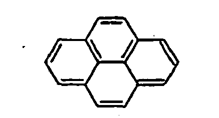 | 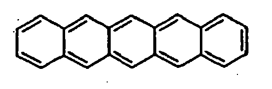 | 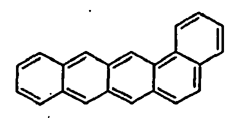 |
| Formel (7) | Formel (8) | Formel (9) |
| 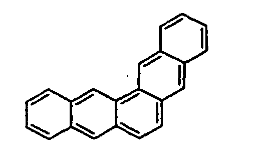 | 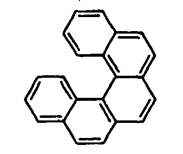 | 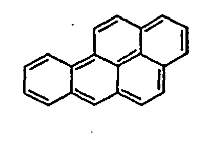 |
| Formel (10) | Formel (11) | Formel (12) |
| 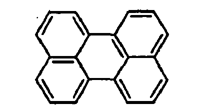 | 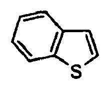 | 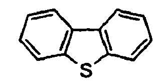 |
| Formel (13) | Formel (14) | Formel (15) |
| 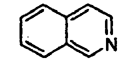 | 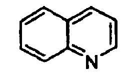 | 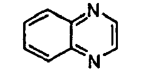 |
| Formel (16) | Formel (17) | Formel (18) |
| 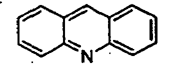 | 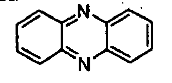 | 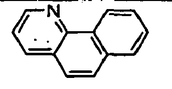 |
| Formel (19) | Formel (20) | Formel (21) |
| 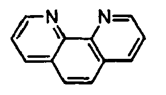 | 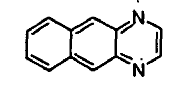 | 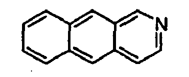 |
| Formel (22) | Formel (23) | Formel (24) |

Dabei gilt für R:
- R: ist bei jedem Auftreten gleich oder verschieden H, F, Cl, Br, I, NO₂, CN, eine geradkettige, verzweigte oder cyclische Alkyl- oder Alkoxygruppe mit 1 bis 40 C-Atomen, wobei ein oder mehrere nicht benachbarte CH₂-Gruppen durch C=O, C=NR¹, -R¹C=CR¹-, -C≡C-, -O-, -S-, -NR¹-, Si(R¹)₂ oder -CONR¹- ersetzt sein können und wobei ein oder mehrere H-Atome durch F, Cl, Br, I, CN, NO₂ ersetzt sein können, oder ein aromatisches oder heteroaromatisches Ringsystem mit 4 bis 40 C-Atomen, das durch einen oder mehrere nicht-aromatische Reste R substituiert sein kann, oder eine Kombination aus zwei bis vier dieser Gruppen; dabei können zwei oder mehrere Substituenten R zusammen wiederum ein weiteres mono- oder polycyclisches, aliphatisches oder aromatisches Ringsystem aufspannen;
- R¹: ist gleich oder verschieden bei jedem Auftreten H oder ein aliphatischer oder aromatischer Kohlenwasserstoffrest mit 1 bis 20 C-Atomen; dabei können zwei oder mehrere Reste R¹ oder R¹ zusammen mit R auch ein weiteres mono- oder polycyclisches, aliphatisches oder aromatisches Ringsystem aufspannen.

Unter einem aromatischen bzw. heteroaromatischen Ringsystem im Sinne dieser Erfindung soll ein System verstanden werden, das nicht notwendigerweise nur aromatische bzw. heteroaromatische Gruppen enthält, sondern in dem auch mehrere aromatische bzw. heteroaromatische Gruppen durch eine kurze nichtaromatische Einheit (weniger als 10 % der von H verschiedenen Atome, bevorzugt weniger als 5 % der von H verschiedenen Atome), wie beispielsweise sp³-hybridisierte C-, O- oder N-Atome etc., unterbrochen sein können. So sollen im Sinne dieser Erfindung also beispielsweise auch Systeme wie 9,9'-Spirobifluoren, 9,9-Diarylfluoren, Triarylamin, Diarylether, etc. als aromatische Ringsysteme verstanden werden.

Weisen die kondensierten aromatischen Ringsysteme bzw. die Einheiten gemäß Formel (1) bis (24) nur eine Verknüpfung zum Polymer auf, bedeutet dies den Einbau dieser Einheiten in die Seitenkette des Polymers. Weisen die kondensierten aromatischen Ringsysteme bzw. die Einheiten gemäß Formel (1) bis (24) zwei Verknüpfungen zum Polymer auf, bedeutet dies den Einbau dieser Einheiten in die Hauptkette des Polymers. Weisen die kondensierten aromatischen Ringsysteme bzw. die Einheiten gemäß Formel (1) bis (24) mehr als zwei Verknüpfungen zum Polymer auf, bedeutet dies eine Verzweigung der Polymerkette.

Die Polymere enthalten bevorzugt neben den kondensierten aromatischen Ringsystemen noch weitere Strukturelemente. Hier sei vor allem auch auf die relativ umfangreichen Auflistungen in WO 02/077060 und die darin aufgeführten Zitate verwiesen. Diese weiteren Struktureinheiten können beispielsweise aus den im Folgenden beschriebenen Gruppen stammen:
Gruppe 1: Comonomere, welche das Polymer-Grundgerüst darstellen:
   Einheiten dieser Gruppe sind aromatische, carbocyclische Strukturen mit 6 bis 40 C-Atomen. Hier kommen Fluoren-Derivate (z. B. EP 0842208, WO 99/54385, WO 00/22027, WO 00/22026, WO 00/46321) in Betracht. Des Weiteren sind auch Spirobifluoren-Derivate (z. B. EP 0707020, EP 0894107, WO 03/020790) eine Möglichkeit. Auch Polymere, die eine Kombination der beiden erstgenannten Monomer-Einheiten enthalten, wie in WO 02/077060 offenbart, wurden bereits vorgeschlagen. Es sind aber auch andere Strukturelemente möglich, die die Morphologie, aber auch die Emissionsfarbe der resultierenden Polymere beeinflussen können. Bevorzugt sind dabei substituierte oder unsubstituierte aromatische Strukturen, die 6 bis 40 C-Atome aufweisen der auch Stilben-, Bisstyrylarylen- oder Tolanderivate, wie z. B. 1,4-Phenylen-, Tetrahydropyrenylen-, Dihydrophenanthrenylen-, 4,4'-Biphenylylen-, 4,4"-Terphenylylen-, Indenofluorenylen-, 4,4'-Stilbenyl-, 4,4"-Bisstyrylarylen- oder 4,4'-Tolanylenderivate. Bevorzugt Einheiten für das Polymergrundgerüst sind Spirobifluorene und Fluorene.
Gruppe 2: Comonomere mit hoch liegendem HOMO:
   Dies sind im Allgemeinen aromatische Amine oder elektronenreiche Heterocyclen, wie beispielsweise substituierte oder unsubstituierte Triarylamine, Benzidine, Tetraarylen-para-phenylendiamine, Phenothiazine, Phenoxazine, Dihydrophenazine, Thianthrene, Dibenzo-p-dioxine, Phenoxathiine. Carbazole, Azulene, Thiophene, Pyrrole, Furane und weitere O-, S- oder N-haltige Heterocyclen mit hoch liegendem HOMO (HOMO = höchst liegendes besetztes Molekülorbital).
Gruppe 3: Comonomere mit niedrig liegendem LUMO:
   Dies sind im Allgemeinen elektronenarme Aromaten oder Heterocyclen, wie beispielsweise substituierte oder unsubstituierte Pyridine, Pyrimidine, Pyridazine, Pyrazine oder Oxadiazole, aber auch Verbindungen wie Triarylborane und weitere O-, S- der N-haltige Heterocyclen mit niedrig liegendem LUMO (LUMO = niedrigstes unbesetztes Molekülorbital).

Dabei ist es auch zulässig, wenn gleichzeitig mehr als eine Struktureinheit aus einer der Gruppen 1-3 vorliegt.

Das Polymer kann weiterhin in die Haupt- oder Seitenkette gebundene Metallkomplexe enthalten, die im Allgemeinen aus einem oder mehreren Liganden und einem oder mehreren Metallzentren aufgebaut sind. Wenn solche Comonomere vorhanden sind, ist die Verwendung separater schweratomhaltiger Verbindungen als Sensibilisatoren nicht unbedingt erforderlich, um gute Effizienzen bei der Up-conversion zu erzielen.

Bevorzugt sind Polymere, die gleichzeitig neben kondensierten aromatischen Ringsystemen zusätzlich noch eine oder mehrere Einheiten ausgewählt aus den Gruppen 1 bis 3 enthalten. Besonders bevorzugt sind hier Polymere, die neben kondensierten aromatischen Ringsystemen noch Einheiten aus der Gruppe 1 enthalten, ganz besonders bevorzugt mindestens 30 mol% dieser Einheiten.

Weiterhin bevorzugt ist ein Anteil von 5 - 80 mol% kondensierte aromatische Ringsysteme. Besonders bevorzugt ist ein Anteil von 10 - 50 mol% kondensierte aromatische Ringsysteme.

Die erfindungsgemäßen Copolymere können statistische, alternierende oder blockartige Strukturen aufweisen oder auch mehrere dieser Strukturen abwechselnd besitzen. Ebenso sei an dieser Stelle hervorgehoben, dass das Polymer linear oder verzweigt aufgebaut sein kann oder auch dendritische Strukturen haben kann.

Die erfindungsgemäßen Polymere weisen in der Regel 10 bis 10000, bevorzugt 20 bis 5000, besonders bevorzugt 50 bis 2000 Wiederholeinheiten auf.

Die nötige Löslichkeit der Polymere wird v. a. durch die Substituenten an den verschiedenen Wiederholeinheiten gewährleistet, sowohl den Substituenten an den kondensierten aromatischen Ringsystemen, wie auch durch Substituenten an den anderen Wiederholeinheiten.

Polymere, die Spirobifluoren als Grundgerüst enthalten und verschiedene kondensierte aromatische Ringsysteme enthalten können, ebenso wie die Synthese dieser Monomereinheiten und Polymere, sind beispielsweise in WO 03/020790 ausführlich beschrieben.

Durch die Verwendung von Polymeren, deren Triplett-Niveau tiefer liegt als das Triplett-Niveau des verwendeten Sensibilisators und/oder die kondensierte aromatische Ringsysteme enthalten, erhält man eine deutliche Effizenzsteigerung der Up-conversion von mehr als einer Größenordnung gegenüber dem in Adv. Mater. 2003, 15, 2095 beschriebenen System aus Polyfluoren und Platin-Porphyrin (PtOEP), für das dieses Verhältnis der Triplett-Energien nicht zutrifft, das keine kondensierten aromatischen Ringsysteme enthält und das den nächstliegenden Stand der Technik darstellt. Dies trifft insbesondere dann zu, wenn das Triplett-Niveau des Polymers tiefer liegt als das des Sensibilisators und wenn das Polymer kondensierte aromatische Ringsysteme enthält. Der genaue Mechanismus der Up-conversion in PtOEP-dotierten Polyfluoren-Filmen ist bislang nicht geklärt. Deshalb ist es auch nicht offensichtlich, weshalb das Phänomen der Up-conversion in den erfindungsgemäßen Systemen um eine Größenordnung effizienter ist als mit einfachen Systemen gemäß dem Stand der Technik; Die oben beschriebenen Ergebnisse sind daher unerwartet und überraschend. Ohne an eine bestimmte Theorie gebunden sein zu wollen, vermuten wir, dass möglicherweise die vom Sensibilisator auf das Polymer übertragenen Triplett-Zustände dort nachfolgend annihilieren (Triplett-Triplett-Annihilation) und einen angeregten Singulett-Zustand des Polymers bilden könnten, der dann blaue Fluoreszenz emittiert. Erst die Copolymerisation mit kondensierten aromatischen Ringsystemen oder anderen Einheiten, die zu einem niedrigeren Triplett-Niveau als dem des Sensibilisators führen, resultiert in einer deutlichen Erhöhung der Effizienz der Up-conversion.

Weiterhin Gegenstand der Erfindung sind Systeme zur Up-conversion, enthaltend mindestens ein Polymer und mindestens einen Sensibilisator, der mindestens ein Schweratom mit der Ordnungszahl größen 38 enthält, dadurch gekennzeichnet, dass das Triplett-Niveau des Sensibilisators höher liegt als das des Polymers und/oder dass das Polymer mindestens 1 mol% kondensierte aromatische Ringsysteme enthält. Dabei gelten auch hier die oben für die Verwendung dieser Systeme gemachten Bevorzugungen.

Weiterer Gegenstand der Erfindung sind optische und/oder elektronische Vorrichtungen zur Up-conversion, enthaltend mindestens ein Polymer und mindestens einen Sensibilisator, der mindestens ein Schweratom mit der Ordnungszahl größen 38 enthält, dadurch gekenneichnet, dass das Triplett-Niveau des Sensibilisators höher liegt als das des Polymers und/oder dass das Polymer mindestens 1 mol% kondensierte aromatische Ringsysteme enthält. Diese Vorrichtungen können beispielsweise organische Solarzellen (O-SC) sein, aber auch weitere optische bzw. elektronische Vorrichtungen, z. B. organischen Leuchtdioden (OLED) oder organische Laser (O-Laser).

Obwohl sich die oben gemachten Beschreibungen nur auf Systeme mit Polymeren beziehen, ist es für den Fachmann ein Leichtes, diese Beschreibungen ohne weiteres erfinderisches Zutun auf Oligomere und Dendrimere zu übertragen. Die Verwendung solcher Oligomere und Dendrimere ist also auch Gegenstand der vorliegenden Erfindung.

Die Erfindung wird durch die nachfolgenden Beispiele näher erläutert, ohne sie darauf einschränken zu wollen.

### Beispiele:

### Beispiel 1: Monomer-Synthesen

Die Strukturen der Monomere (**M**) sind im Folgenden abgebildet. Die Synthesen sind in WO 03/020790 und der darin zitierten Literatur niedergelegt.
9,10-Dibromanthracen wurde von Aldrich erhalten und durch Umkristallisation aus Dioxan weiter gereinigt.

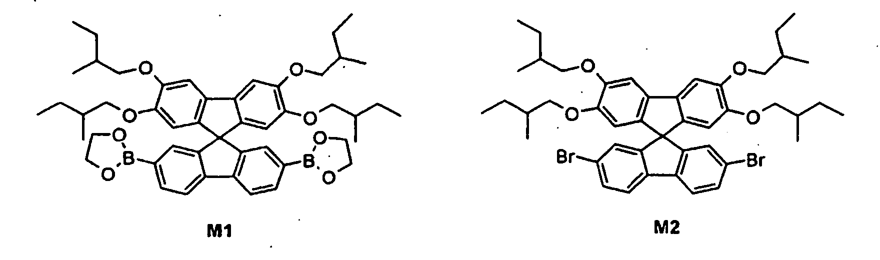

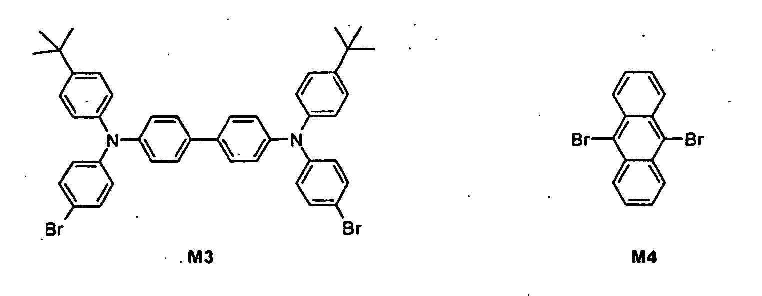

### Beispiel 2: Polymer-Synthesen

Die Polymere wurden durch SUZUKI-Kupplung gemäß WO 03/048225 synthetisiert. Die Zusammensetzung des hier verwendeten Polymers **P1** ist 50 mol% **M1,** 10 mol% **M2**, 10 mol% **M3** und 30 mol% **M4.**
Als Vergleichspolymer V1 wurde Poly-[2,7-(9,9-bis(2-ethylhexyl)fluoren)] (H. G. Nothofer et al., Macromol. Symp. 2000, 154, 139) gemäß dem nächstliegenden Stand der Technik verwendet (P. E. Keivanidis et al., Adv. Mater. 2003, 15, 2095). Als weiteres Vergleichs polymer **V2** wurde ein Spirobifluoren-Homopolymer aus 50 mol% **M1** und 50 mol% **M2** verwendet, das das gleiche Polymergrundgerüst wie das Polymer **P1,** jedoch keine kondensierten aromatischen Ringsysteme enthält. Beide Vergleichspolymere sind dem Polymer **P1** strukturell und/oder elektronisch ähnlich.

### Beispiel 3: Bestimmung der Triplett-Energien

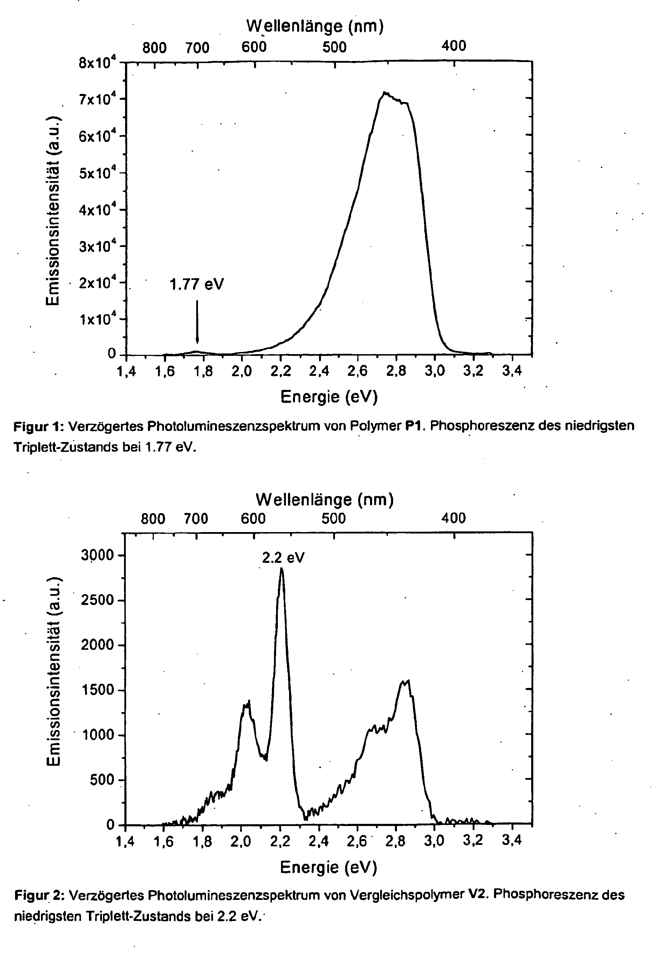

Die Triplett-Energien der Verbindungen wurden mittels zeitaufgelöster Photolumineszenz-Spektroskopie bestimmt. Einzelheiten zur experimentellen Vorgehensweise sind in der Literatur (D. Hertel et al., J. Chem. Phys. 2002, 115, 10007) beschrieben.
Für das Anthracen-Spirobifluoren-Copolymer **P1** wurde die niedrigste Triplett-Energie spektroskopisch zu 1.77 eV bestimmt (Figur 1). Die Triplett-Energie des Vergleichspolymers **V1** liegt bei 2.18 eV, wie in der Literatur (D. Hertel et al., J. Chem. Phys. 2002, 115, 10007) beschrieben. Die niedrigste Triplett-Energie des Vergleichspolymers **V2** wurde spektroskopisch zu 2.2 eV (Figur 2) bestimmt. Im beschriebenen Testsystem liegt die Triplett-Energie des Sensibilisators PtOEP bei 1.91 eV. Damit liegt die Triplett-Energie des Sensibilisators höher als die des Polymers **P1,** jedoch niedriger als die der Vergleichspolymere **V1** und **V2.**

### Beispiel 4: Verwendung von Polymer P1 und Vergleichspolymeren V1 und V2 in der Up-conversion

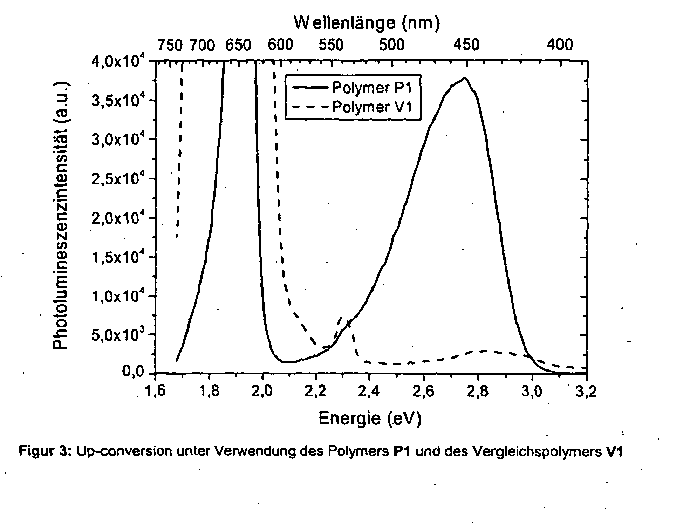

Das untersuchte Testsystem bestand aus dem in Beispiel 2 beschriebenen Anthracen-Spirobifluoren-Copolymer **P1** bzw. den Vergleichspolymeren **V1** und **V2,** dotiert mit Platin-octaethylporphyrin (PtOEP) in Gewichtskonzentrationen von 0.1 bis 2.0 Gew.% (bezogen auf das Polymer). Zur spektroskopischen Charakterisierung der Mischungen wurden dünne Filme auf Quarzsubstraten mittels Spin-coating hergestellt. Die Proben wurden in einem evakuierten Probenhalter (10⁻⁶ mbar) mit Hilfe eines gepulsten OPO Lasersystems mit einer Energie von 2.31 eV (537 nm) entsprechend dem S₀ → S₁ 0-0 Übergang des PtOEP angeregt. Das von der Probe emittierte Licht wurde mittels eines Spektrometers spektral zerlegt und von einem Optischen Multikanal Analysator (OMA III, EG&G) detektiert. Zur Messung der Up-conversion wurde ein Detektionsfenster von 10 ms mit einer Verzögerung von 50 ns bezüglich des Anregungspulses gewählt. Die typische Anregungsleistung lag bei 50 µJ / Puls bei einem Spotdurchmesser von 2 mm. Zur Verbesserung des Signal-Rausch-Verhältnisses wurden über 100 Laserpulse akkumuliert. Bei Anregung des Dotanden PtOEP wurde dabei eine blaue Fluoreszenz der Polymer-Matrix beobachtet. Diese ist nicht auf direkte Anregung des Polymers **P1** zurückzuführen, da dieses bei der Anregungsenergie von 2.31 eV (537 nm) nicht absorbiert. Die Lumineszenz muss folglich durch die Anwesenheit des Dotanden verursacht sein. Weiterhin wurde im direkten Vergleich gefunden, dass die Intensität der blauen Fluoreszenz mit Polymer **P1** um einen Faktor 10 (ca. von 1 : 300 auf mehr als 1 : 30) intensiver ist als bei Verwendung einer Matrix aus Polyfluoren **V1** (Figur 3) gemäß dem Stand der Technik. Die Up-conversion im Polymer **P1** ist damit um eine Größenordnung effizienter als bislang bei blau emittierenden konjugierten Polymeren beschrieben.
Es wurde weiterhin gefunden, dass für die Lage der Triplett-Niveaus und damit für die Verbesserung der Effizienz der Up-conversion die Anwesenheit von Anthracen in diesem Copolymer entscheidend ist: Ein Vergleich mit einer Matrix aus einem Poly-Spirobifluoren-Homopolymer **V2** zeigte, dass die Up-conversion in diesem Material vergleichbar mit der Up-conversion in dotiertem Polyfluoren **V1** ist.

## Patentansprüche

1. Verwendung von Systemen, enthaltend mindestens ein Polymer und mindestens einen Sensibilisator, der mindestens ein Schweratom mit der Ordnungszahl größer 38 enthält, für Up-conversion, **dadurch gekennzeichnet, dass** das Triplett-Niveau des Sensibilisators höher liegt als das Triplett-Niveau des Polymers.

2. Verwendung von Systemen gemäß Anspruch 1, **dadurch gekennzeichnet, dass** das Triplett-Niveau des Sensibilisators höher liegt als das Triplett-Niveau des Polymers und dass das Polymer mindestens 1 mol% kondensierte aromatische Ringsysteme enthält.

3. Verwendung von Systemen gemäß Anspruch 1 oder 2, **dadurch gekennzeichnet, dass** das Polymer konjugiert ist.

4. Verwendung von Systemen gemäß einem oder mehreren der Ansprüche 1 bis 3, **dadurch gekennzeichnet, dass** das Triplett Niveau des Sensibilisators mindestens 0.05 eV höher liegt als das Triplett-Niveau des Polymers.

5. Verwendung von Systemen gemäß Anspruch 4, **dadurch gekennzeichnet, dass** das Triplett-Niveau des Sensibilisators mindestens 0.1 eV höher liegt als das Triplett-Niveau des Polymers.

6. Verwendung von Systemen gemäß einem oder mehreren der Ansprüche 2 bis 5, **dadurch gekennzeichnet, dass** der Anteil kondensierter aromatischer Ringsysteme 5-80 mol% beträgt.

7. Verwendung von Systemen gemäß Anspruch 6, **dadurch gekennzeichnet, dass** der Anteil kondensierter aromatischer Ringsysteme 10 bis 50 mol% beträgt.

8. Verwendung von Systemen gemäß einem oder mehreren der Ansprüche 2 bis 7, **dadurch gekennzeichnet, dass** die kondensierten aromatischen Ringsysteme in die Polymerhauptkette eingebaut sind.

9. Verwendung von Systemen gemäß einem oder mehreren der Ansprüche 2 bis 8, **dadurch gekennzeichnet, dass** die kondensierten aromatischen Ringsysteme zwischen zwei und acht aromatische Einheiten enthalten, die jeweils über eine oder mehrere gemeinsame Kanten einander ankondensiert sind und **dadurch** ein gemeinsames aromatisches System ausbilden und die substituiert oder unsubstituiert sein können, wobei die Substituenten noch weitere Ringsysteme bilden können.

10. Verwendung von Systemen gemäß Anspruch 9, **dadurch gekennzeichnet, dass** die kondensierten aromatischen Ringsysteme zwischen drei und fünf aromatische Einheiten enthalten, die jeweils über eine oder mehrere gemeinsame Kanten einander ankondensiert sind und **dadurch** ein gemeinsames aromatisches System ausbilden und die substituiert oder unsubstituiert sein können, wobei die Substituenten noch weitere Ringsysteme bilden können.

11. Verwendung von Systemen gemäß Anspruch 9 und/oder 10, **dadurch gekennzeichnet, dass** die einander ankondensierten aromatischen Einheiten ausgewählt sind aus Benzol, Pyridin, Pyrimidin, Pyrazin, Pyridazin und Thiophen, die substituiert oder unsubstituiert sein können.

12. Verwendung von Systemen gemäß einem oder mehreren der Ansprüche 9 bis 11, **dadurch gekennzeichnet, dass** die kondensierten aromatischen Ringsysteme ausgewählt sind aus Strukturen gemäß den Formeln (1) bis (24):
| | | |
|---|---|---|
| 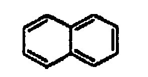 | 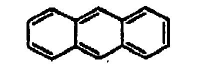 | 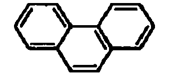 |
| Formel (1) | Formel (2) | Formel (3) |
| 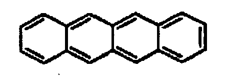 | 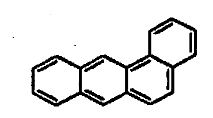 | 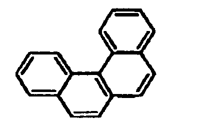 |
| Formel (4) | Formel (5) | Formel (6) |
| 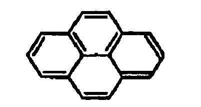 | 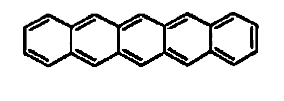 | 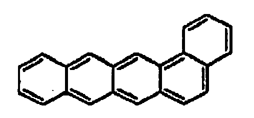 |
| Formel (7) | Formel (8) | Formel (9) |
| 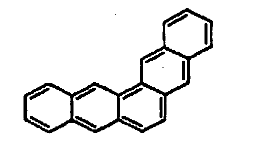 | 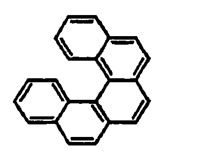 | 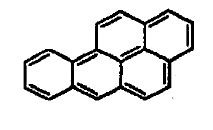 |
| Formel (10) | Formel (11) | Formel (12) |
| 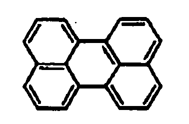 | 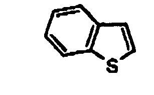 | 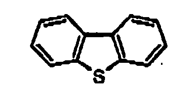 |
| Formel (13) | Formel (14) | Formel (15) |
| 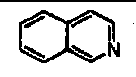 | 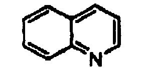 | 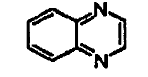 |
| Formel (16) | Formel (17) | Formel (18) |
| 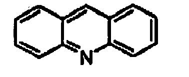 | 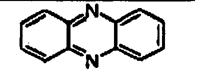 | 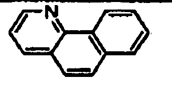 |
| Formel (19) | Formel (20) | Formel (21) |
| 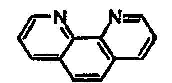 | 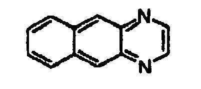 | 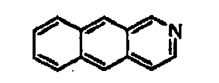 |
| Formel (22) | Formel (23) | Formel (24) |

13. Verwendung von Systemen gemäß einem oder mehreren der Ansprüche 2 bis 12, **dadurch gekennzeichnet, dass** die Polymere neben den kondensierten aromatischen Ringsystemen noch weitere Strukturelemente enthalten, die ausgewählt sind aus Fluoren-Derivaten, Spirobifluoren-Derivaten, 1,4-Phenylenderivaten, Dihydrophenanthrenylenderivaten, Tetrahydropyrenylenderivaten, 4,4'-Biphenylylendenvaten, 4,4"-Terphenylylenderivaten, Indenofluorenylenderivaten, 4,4'-Stilbenylderivaten, 4,4"-Bisstyrylarylenderivaten, Tolanylenderivaten bzw. Gemische derselben.

14. Verwendung von Systemen gemäß einem oder mehreren der Ansprüche 1 bis 13, **dadurch gekennzeichnet, dass** das Polymer in die Haupt- oder Seitenkette gebundene Metallkomplexe enthält.

15. Systeme für Up-conversion, enthaltend mindestens ein Polymer und mindestens einen Sensibilisators, der mindestens ein Schweratom mit der Ordnungszahl größer 38 enthält, **dadurch gekennzeichnet, dass** das Triplett-Niveau des Sensibilisators höher liegt als das Triplett-Niveau des Polymers.

16. Optische und/oder elektronische Vorrichtungen zur Up-conversion enthaltend mindestens ein System gemäß Anspruch 15.

17. Optische und/oder elektronische Vorrichtung gemäß Anspruch 16, **dadurch gekennzeichnet, dass** es sich um eine organische Solarzelle, eine organische Leuchtdiode oder einen organischen Laser handelt.

## Claims

1. Use of systems comprising at least one polymer and at least one sensitiser containing at least one heavy atom having an atomic number greater than 38 for up-conversion, **characterised in that** the triplet level of the sensitiser is higher than the triplet level of the polymer.

2. Use of systems according to Claim 1, **characterised in that** the triplet level of the sensitiser is higher than the triplet level of the polymer and **in that** the polymer contains at least 1 mol% of condensed aromatic ring systems.

3. Use of systems according to Claim 1 or 2, **characterised in that** the polymer is conjugated.

4. Use of systems according to one or more of Claims 1 to 3, **characterised in that** the triplet level of the sensitiser is at least 0.05 eV higher than the triplet level of the polymer.

5. Use of systems according to Claim 4, **characterised in that** the triplet level of the sensitiser is at least 0.1 eV higher than the triplet level of the polymer.

6. Use of systems according to one or more of Claims 2 to 5, **characterised in that** the proportion of condensed aromatic ring systems is 5 - 80 mol%.

7. Use of systems according to Claim 6, **characterised in that** the proportion of condensed aromatic ring systems is 10 to 50 mol%.

8. Use of systems according to one or more of Claims 2 to 7, **characterised in that** the condensed aromatic ring systems are incorporated into the polymer main chain.

9. Use of systems according to one or more of Claims 2 to 8, **characterised in that** the condensed aromatic ring systems contain between two and eight aromatic units, which are in each case condensed onto one another via one or more common edges and thus form a common aromatic system and which may be substituted or unsubstituted, where the substituents may form further ring systems.

10. Use of systems according to Claim 9, **characterised in that** the condensed aromatic ring systems contain between three and five aromatic units, which are in each case condensed onto one another via one or more common edges and thus form a common aromatic system and which may be substituted or unsubstituted, where the substituents may form further ring systems.

11. Use of systems according to Claim 9 and/or 10, **characterised in that** the aromatic units condensed onto one another are selected from benzene, pyridine, pyrimidine, pyrazine, pyridazine and thiophene, each of which may be substituted or unsubstituted.

12. Use of systems according to one or more of Claims 9 to 11, **characterised in that** the condensed aromatic ring systems are selected from structures of the formulae (1) to (24):
| | | |
|---|---|---|
| 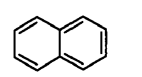 | 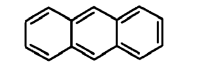 | 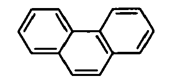 |
| Formula (1) | Formula (2) | Formula (3) |
| 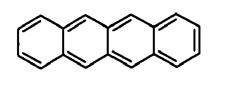 | 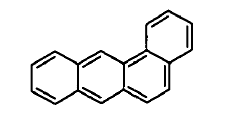 | 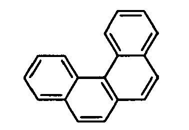 |
| Formula (4) | Formula (5) | Formula (6) |
| 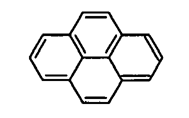 | 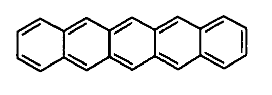 | 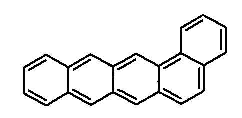 |
| Formula (7) | Formula (8) | Formula (9) |
| 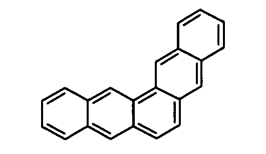 | 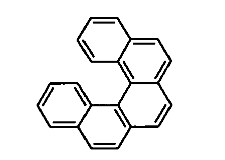 | 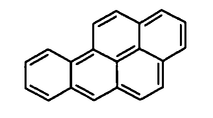 |
| Formula (10) | Formula (11) | Formula (12) |
| 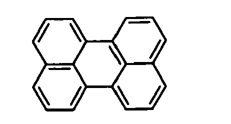 | 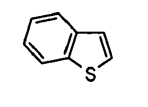 | 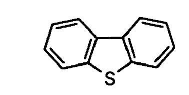 |
| Formula (13) | Formula (14) | Formula (15) |
| 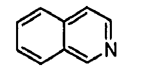 | 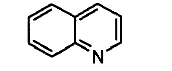 | 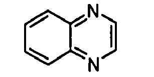 |
| Formula (16) | Formula (17) | Formula (18) |
| 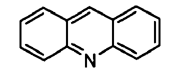 | 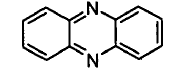 | 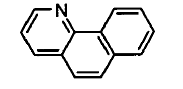 |
| Formula (19) | Formula (20) | Formula (21) |
| 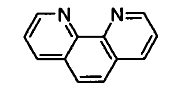 | 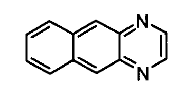 | 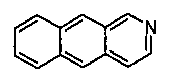 |
| Formula (22) | Formula (23) | Formula (24) |

13. Use of systems according to one or more of Claims 2 to 12, **characterised in that**, besides the condensed aromatic ring systems, the polymers also contain further structural elements which are selected from fluorene derivatives, spirobifluorene derivatives, 1,4-phenylene derivatives, dihydrophenanthrenylene derivatives, tetrahydropyrenylene derivatives, 4,4'-biphenylylene derivatives, 4,4"-terphenylylene derivatives, indenofluorenylene derivatives, 4,4'-stilbenyl derivatives, 4,4"-bisstyrylarylene derivatives, tolanylene derivatives and mixtures thereof.

14. Use of systems according to one or more of Claims 1 to 13, **characterised in that** the polymer contains metal complexes bonded into the main chain or side chain.

15. Systems for up-conversion comprising at least one polymer and at least one sensitiser containing at least one heavy atom having an atomic number greater than 38, **characterised in that** the triplet level of the sensitiser is higher than the triplet level of the polymer.

16. Optical and/or electronic devices for up-conversion containing at least one system according to Claim 15.

17. Optical and/or electronic device according to Claim 16, **characterised in that** it is an organic solar cell, an organic light-emitting diode or an organic laser.

## Revendications

1. Utilisation de systèmes comprenant au moins un polymère et au moins un sensibilisateur contenant au moins un atome lourd ayant un nombre atomique supérieur à 38 pour la conversion ascendante, **caractérisée en ce que** le niveau triplet du sensibilisateur est supérieur au niveau triplet du polymère.

2. Utilisation de systèmes selon la revendication 1, **caractérisée en ce que** le niveau triplet du sensibilisateur est supérieur au niveau triplet du polymère et **en ce que** le polymère contient au moins 1% molaire de noyaux aromatiques condensés.

3. Utilisation de systèmes selon la revendication 1 ou 2, **caractérisée en ce que** le polymère est conjugué.

4. Utilisation de systèmes selon l'une ou plusieurs parmi les revendications 1 à 3, **caractérisée en ce que** le niveau triplet du sensibilisateur est supérieur d'au moins 0,05 eV par rapport au niveau triplet du polymère.

5. Utilisation de systèmes selon la revendication 4, **caractérisée en ce que** le niveau triplet du sensibilisateur est supérieur d'au moins 0,1 eV par rapport au niveau triplet du polymère.

6. Utilisation de systèmes selon l'une ou plusieurs parmi les revendications 2 à 5, **caractérisée en ce que** la proportion en noyaux aromatiques condensés est de 5 - 80% molaire.

7. Utilisation de systèmes selon la revendication 6, **caractérisée en ce que** la proportion en noyaux aromatiques condensés est de 10 à 50% molaire.

8. Utilisation de systèmes selon l'une ou plusieurs parmi les revendications 2 à 7, **caractérisée en ce que** les noyaux aromatiques condensés sont incorporés dans la chaîne principale du polymère.

9. Utilisation de systèmes selon l'une ou plusieurs parmi les revendications 2 à 8, **caractérisée en ce que** les noyaux aromatiques condensés contiennent entre deux et huit motifs aromatiques, qui sont dans chaque cas condensés les uns sur les autres par un ou plusieurs bords communs et forment ainsi un noyau aromatique commun et qui peuvent être substitués ou non, où les substituants peuvent former des noyaux supplémentaires.

10. Utilisation de systèmes selon la revendication 9, **caractérisée en ce que** les noyaux aromatiques condensés contiennent entre trois et cinq motifs aromatiques, qui sont dans chaque cas condensés les uns sur les autres par un ou plusieurs bords communs et forment ainsi un noyau aromatique commun et qui peuvent être substitués ou non, où les substituants peuvent former des noyaux supplémentaires.

11. Utilisation de systèmes selon la revendication 9 et/ou 10, **caractérisée en ce que** les motifs aromatiques condensés les uns sur les autres sont sélectionnés parmi le benzène, la pyridine, la pyrimidine, la pyrazine, la pyridazine et le thiophène, chacun desquels pouvant être substitué ou non.

12. Utilisation de systèmes selon l'une ou plusieurs parmi les revendications 9 à 11, **caractérisée en ce que** les noyaux aromatiques condensés sont sélectionnés parmi les structures des formules (1) à (24):
| | | |
|---|---|---|
| 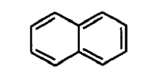 | 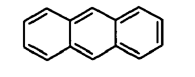 | 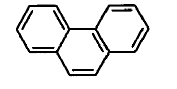 |
| Formule (1) | Formule (2) | Formule (3) |
| 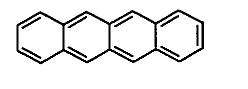 | 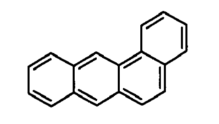 | 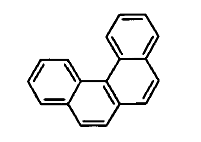 |
| Formule (4) | Formule (5) | Formule (6) |
| 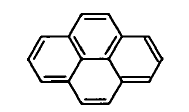 | 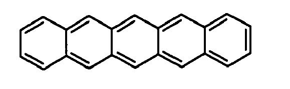 | 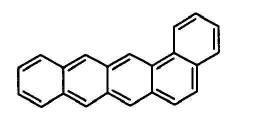 |
| Formule (7) | Formule (8) | Formule (9) |
| 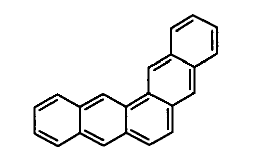 | 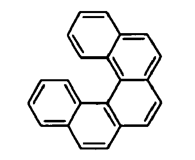 | 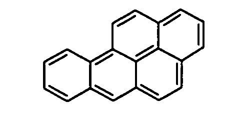 |
| Formule (10) | Formule (11) | Formule (12) |
| 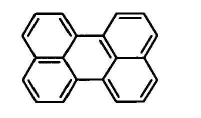 | 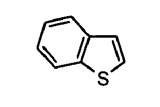 | 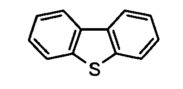 |
| Formule (13) | Formule (14) | Formule (15) |
| 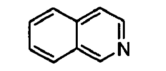 | 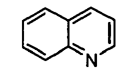 | 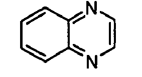 |
| Formule (16) | Formule (17) | Formule (18) |
| 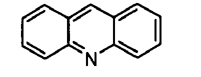 | 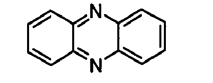 | 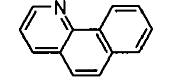 |
| Formule (19) | Formule (20) | Formule (21) |
| 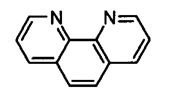 | 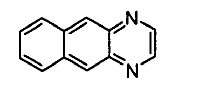 | 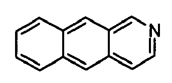 |
| Formule (22) | Formule (23) | Formule (24) |

13. Utilisation de systèmes selon l'une ou plusieurs parmi les revendications 2 à 12, **caractérisée en ce que**, outre les noyaux aromatiques condensés, les polymères contiennent aussi d'autres éléments structuraux sélectionnés parmi les dérivés de fluorène, les dérivés de spirobifluorène, les dérivés de 1,4-phénylène, les dérivés de dihydrophénanthrénylène, les dérivés de tétrahydropyrénylène, les dérivés de 4,4'-biphénylylène, les dérivés de 4,4"-terphénylylène, les dérivés d'indénofluorénylène, les dérivés de 4,4'-stilbényle, les dérivés de 4,4"-bis-styrylarylène, les dérivés de tolanylène, et des mélanges de ceux-ci.

14. Utilisation de systèmes selon l'une ou plusieurs parmi les revendications 1 à 13, **caractérisée en ce que** le polymère contient des complexes métalliques liés à la chaîne principale ou à une chaîne latérale.

15. Systèmes de conversion ascendante, comprenant au moins un polymère et au moins un sensibilisateur contenant au moins un atome lourd ayant un nombre atomique supérieur à 38, **caractérisés en ce que** le niveau triplet du sensibilisateur est supérieur au niveau triplet du polymère.

16. Dispositifs optiques et/ou électroniques de conversion ascendante, contenant au moins un système selon la revendication 15.

17. Dispositif optique et/ou électronique selon la revendication 16, **caractérisé en ce qu'**il s'agit d'une cellule solaire organique, d'une diode électroluminescente organique ou d'un laser organique.
